# EUROPEAN PATENT SPECIFICATION

(11) **EP 0 348 562 B1**
(45) Date of publication and mention of the grant of the patent: **16.06.1993**
(21) Application number: 88305858.8
(22) Date of filing: 28.06.1988
(51) Int. Cl.: H01R 9/09, H01R 13/24, H01R 17/12

(54) **High-density contact area electrical connectors**
Elektrische Steckverbinder mit Kontaktflächen hoher Dichte
Connecteurs électriques à haute densité de surfaces de contacts

(43) Date of publication of application: 03.01.1990
(73) Proprietor: TRW INC., Cleveland Ohio 44124 (US)
(72) Inventor: Smolley, Robert, Porteugese Bend California 90274 (US)
(74) Representative: Allden, Thomas Stanley

(56) References cited:
- FR-A- 1 541 981
- US-A- 3 324 445
- US-A- 4 520 562

## Description

This invention relates generally to electrical connectors.

Electrical connectors allow large electronic systems and subsystems to be assembled from many smaller electronic components, such as circuit boards, thus simplifying the manufacture, installation and maintenance of the electronic systems and subsystems. Typically, the circuit boards in these electronic systems and subsystems are interconnected with each other by means of a "mother" board, a large circuit board having edge card connectors into which the circuit boards are plugged. Alternatively, the circuit boards are interconnected by means of these same edge card connectors, but with cable harnesses and cable harness connectors in place of the mother board.

Conventional edge card connectors generally utilize leaf-spring contacts for engaging contact areas at the edges of the circuit boards. Although these types of edge card connectors have many advantages, they do have some disadvantages. One disadvantage is that leaf-spring contacts can become bent and fail to make contact with the circuit board contact areas. Another disadvantage is that leaf-spring contacts have a relatively high electrical resistance. Still another disadvantage is that a comparatively high force is required to engage and disengage the circuit board from the edge card connector. However, the most significant disadvantage is that the contact areas at the circuit board edge require relatively large surface areas, thus severely limiting the number of contacts areas that can be placed along the edge of the circuit board. Circuit boards presently being manufactured are limited to about 250 edge contact areas, but in the very near future, as integrated-circuit chips become more complex, circuit boards having in excess of 400 contact areas will be required.

Conventional cable harness connectors generally utilize male and female parts, such as pins and sockets, for connecting the leads of one cable harness to another. As with edge card connectors, cable harness connectors also have some disadvantages. One disadvantage is that the pins can become bent, thus preventing insertion of the pins into the sockets. Another disadvantage is that pins and sockets have relatively high electrical resistances. Still another disadvantage is that a comparatively high force is required to engage and disengage the cable harness connectors. However, the most significant disadvantage is that the pins and sockets require relatively large surface areas, thus severely limiting the number of contact areas that can be placed in one cable connector.

In US-A-3324445 there is generally disclosed an electrical connector for making electrical connections between contact areas on two electronic components, comprising a connector housing attached to one of the electronic components, an insulating board disposed between the contact areas of the two electronic components, the insulating board having one or more openings at a position or positions corresponding to the contact areas, one or more conductive connector elements disposed respectively in the opening or in selected ones of the openings in the insulating board, and means for urging the connector housing and the two electronic components towards one another thereby compressing the or each conductive connector element and making electrical contact between the contact areas of the two electrical components.

More particularly, in the electrical connector of US-A-3324445 each conductive connector element comprises a bundle of resilient conductors in the form of a length of braided wires.

In accordance with the present invention as claimed, the aforesaid generally disclosed electrical connector is characterised in that the or each conductive connector element includes a wadded strand of conductive wire that is deformed when compressed and makes multiple electrical contacts with the contact areas of the two electronic components.

An electrical connector constructed in accordance with the present invention provides high density contact areas, easy engagement and disengagement of the electronic components, and minimum electrical resistance between the contact areas.

In a presently preferred embodiment of the invention, two cable harnesses are electrically connected by a cable harness connector using the technique of the present invention. The cable harness connector includes a first and second connector housing and an insulating board interposed between the two connector housings. The faces of the first and second connector housings have a plurality of metalized contact areas for connecting the leads of the two cable harnesses. The insulating board has a plurality of circular openings at positions corresponding to the connector housing contact areas. Compressing the connector housings together causes conductive connector elements positioned in the openings to be compressed against the metalized contact areas, thus making electrical connections between the contact areas.

In another presently preferred embodiment of the invention, a circuit board and a mother board, and a circuit board and a cable harness, are electrically connected by an edge card connector using the technique of the present invention. The edge card connector includes a connector housing, an insulating board interposed between the connector housing and the circuit board, and another insulating board interposed between the connector housing and the mother board or between the connector housing and the cable harness. The first insulating board fits within a recessed area of the connector housing, with the recessed area having a plurality of metalized contact areas for connecting leads in the connector housing with a plurality of metalized contact areas along the edge of the circuit board. The bottom face of the connector housing has a plurality of metalized contact areas for connecting the leads in the connector housing with a plurality of metalized contact areas on the mother board or on the face of a cable harness connector housing attached to the cable harness. The insulating boards have a plurality of circular openings at positions corresponding to the contact areas of the connector housing, the circuit board and the mother board or cable harness connector housing. Compressing the connector housing, the circuit board and the mother board or cable harness together causes conductive connector elements positioned in the openings to be compressed against the metalized contact areas, thus making electrical connections between the contact areas.

In still another presently preferred embodiment of the invention, two coaxial cables are electrically connected by a coaxial cable connector using the technique of the present invention. The coaxial cable connector is similar to the cable harness connector, with the exception that the coaxial cable connector has only a single conductive connector element in a circular opening at the center of the insulating board to electrically connect the center conductors of the two coaxial cables. An annular-shaped woven wire mesh, positioned about the circumference of the insulating board, electrically connects the outer conductors of the two coaxial cables.

The wadded strand of conductive wire forming a conductive connector element preferably forms a nearly cylindrical "button" of material having a density of between twenty and thirty percent. Each such wadded-wire connector element fits snugly in an opening of the insulating board and protrudes slightly above and below the insulating board. The wadded-wire connector elements make electrical contact at multiple points when compressed against a contact area. Such connectors have significant advantages over other types of connectors, and provide connections of high integrity and reliability. In contrast to the other types of connectors, the present mechanical connector element has very few associated variables that can affect the quality of the connection. The only significant variables are the size of the connector element and the compressive force used to make the connection, both of which can be accurately controlled.

In order that the present invention may be well understood there will now be described, in more detail, the aforesaid preferred embodiments thereof, which are given by way of example, with reference to the accompanying drawings, in which:
Figure 1 is a fragmentary perspective view of a cable harness connector embodying the present invention;
Figure 2 is a fragmentary, exploded view of a wadded-wire connector element of the same cable harness connector;
Figure 3 is a fragmentary, exploded sectional view of an insulating board with a plurality of wadded-wire connector elements of the same cable harness connector;
Figure 4 is a fragmentary perspective view of an edge card connector embodying the present invention for electrically connecting a circuit board and a mother board;
Figure 5 is a fragmentary sectional view of an edge card connector embodying the present invention for electrically connecting a circuit board and a cable harness; and
Figure 6 is a fragmentary perspective view of a coaxial cable connector embodying the present invention.

As shown in the drawings for purposes of illustration, the present invention is embodied in an improved electrical connector for making electrical connections between electronic components. In large electronic systems and subsystems, circuit boards are typically interconnected with each other by means of a "mother" board, a large circuit board having edge card connectors into which the circuit boards are plugged. Alternatively, the circuit boards can be interconnected by means of these same edge card connectors, but with cable harnesses and cable harness connectors in place of the mother board. However, conventional edge card and cable harness connectors have relatively high electrical resistances, are not easily engaged and disengaged and, most importantly, require relatively large surface areas for making the electrical connections.

In accordance with the present invention, the improved electrical connector includes an insulating board interposed between metalized contact areas on the electronic components. The insulating board has one or more openings at positions corresponding to the contact areas of the electronic components, with electrical connections between the contact areas established with conductive connector elements positioned in the openings of the insulating board. In a presently preferred embodiment of the invention, two cable harnesses are electrically connected by a cable harness connector using the technique of the present invention. In another presently preferred embodiment of the invention, a circuit board and a mother board, and a circuit board and a cable harness, are electrically connected by an edge card connector using the technique of the present invention. In still another presently preferred embodiment of the invention, two coaxial cables are electrically connected by a coaxial cable connector using the technique of the present invention. These improved electrical connectors provide high density contact areas, easy engagement and disengagement of the electronic components, and minimum electrical resistance between the contact areas.

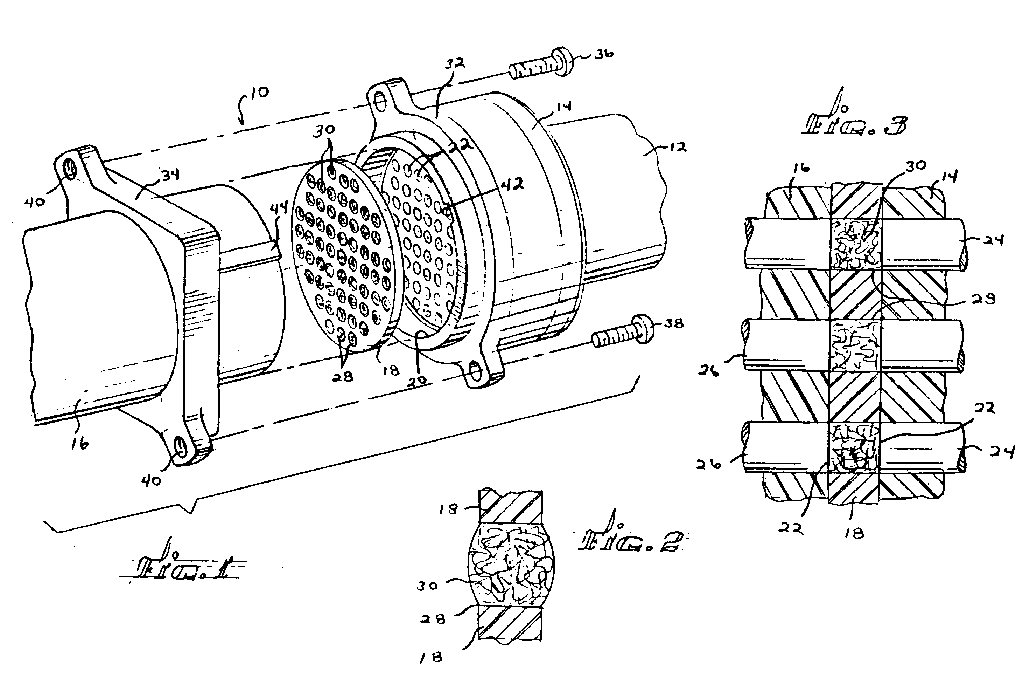

Figure 1 shows a cable harness connector 10 for making electrical connections between a first cable harness 12 and a second cable harness (not shown). The cable harness connector 10 includes a first connector housing 14, a second connector housing 16 and a circular insulating board 18 interposed between the two connector housings 14, 16. The insulating board 18, commonly referred to as a button board, fits within a recessed area 20 of the first connector housing 14. The faces of the first and second connector housings 14, 16 have a plurality of metalized contact areas 22 for connecting leads 24 of cable harness 12 to leads 26 of the other cable harness.

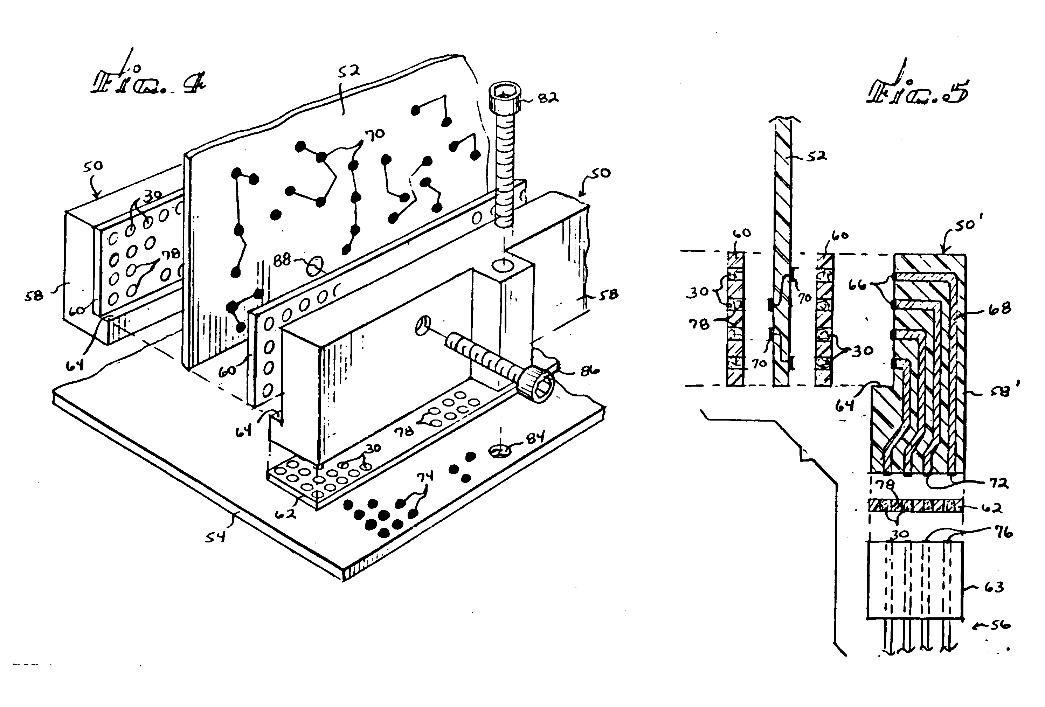

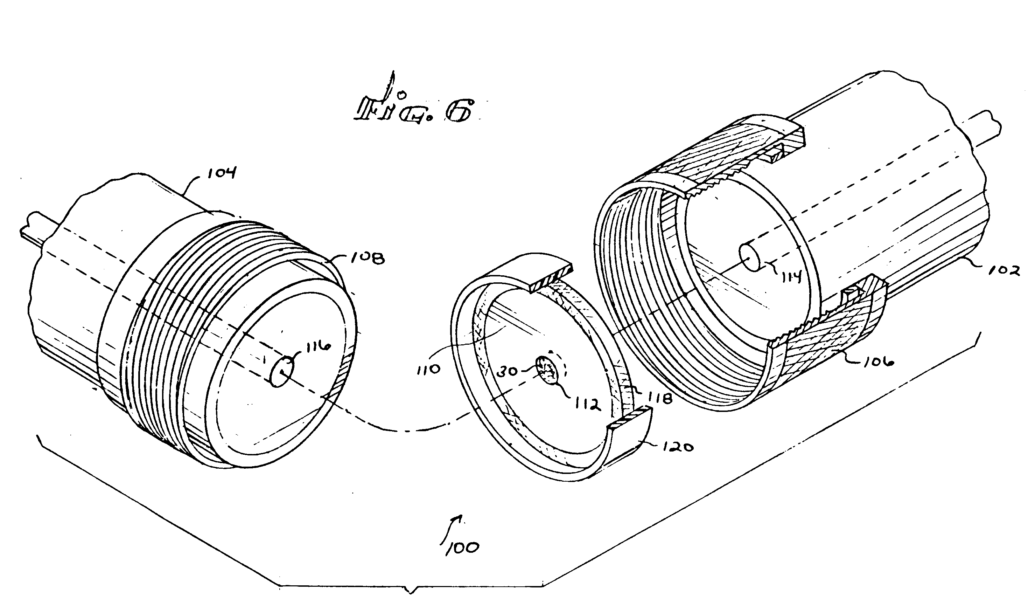

As shown more clearly in Figure 3, the insulating board 18 has a plurality of circular openings 28 at positions corresponding to the connector housing contact areas 22. Electrical connections between the contact areas 22 are established with connector elements 30 positioned in the openings 28 of the insulating board 18. Compressing the two connector housings 14, 16 together causes the connector elements 30 to be compressed against the metalized contact areas 22. Compression is provided by a flange 32 around the outer circumference of the first connector housing 14, a flange 34 around the outer circumference of the second connector housing 16 and two bolts 36, 38. The bolts 36, 38 engage a pair of threaded holes 40 in the flange 34. A slot 42 in the first connector housing 14 engages a key 44 protruding outwardly from the outer surface of the second connector housing 16, thus ensuring proper alignment of the contact areas 22 and the connector elements 30.

The insulating or button board 18 is preferably formed from an insulating material, such as a glass ceramic or a plastic. The connector elements 30 employed in the illustrative embodiments are preferably each formed from a strand of metal wire, each strand being wadded together to form a nearly cylindrical "button" of material having a density of between twenty and thirty percent. As shown in Figure 2, each wadded-wire connector element 30 fits snugly in the opening 28 of the insulating board 18 and protrudes slightly above and below the insulating board 18. The wadded-wire connector elements 30 make electrical contact at multiple points when compressed against a contact area. Connectors of this type have significant advantages over other types of connectors and provide connections of high integrity and reliability. In contrast to the other types of connections, this mechanical connector element has very few associated variables that can affect the quality of the connection. The only significant variables are the size of the connector element and the compressive force used to make the connection, both of which can be accurately controlled.

The wadded-wire connector elements 30 employed in the illustrative embodiments can be fabricated using nickel wire, or wire made from such alloys as beryllium and copper, silver and copper, or phosphorus and bronze. The compression of the wadded-wire connector elements 30 is substantially elastic so that, when the compressive force of the flanges 32, 34 and bolts 36, 38 is removed, the wadded-wire connector elements 30 return to their original shape. This allows the cable harness connector 10 to be taken apart and put back together as many times as is needed. In the embodiments described, the wadded-wire connector elements 30 are manufactured by Technical Wire Products, Inc. of Piscataway, New Jersey, under the trademark Fuzz Button.

Figure 4 shows an edge card connector 50 for making electrical connections between a circuit board 52 and a mother board 54 and Figure 5 shows an edge card connector 50′ for making electrical connections between the circuit board 52 and a cable harness 56. The edge card connector 50 includes a connector housing 58, an insulating board 60 interposed between the connector housing 58 and the circuit board 52, and an insulating board 62 interposed between the connector housing 58 and the mother board 54. The edge card connector 50′ includes a connector housing 58′, an insulating board 60 interposed between the connector housing 58′ and the circuit board 52, and an insulating board 62 interposed between the connector housing 58′ and a cable harness connector housing 63. Each of the insulating boards 60 fits within a recessed area 64 of the connector housings 58, 58′.

As shown in Figure 5, the recessed area 64 of each of the connector housings 58, 58′ has a plurality of metalized contact areas 66 for connecting leads 68 in the connector housings 58, 58′ with a plurality of metalized contact areas 70 along the edge of the circuit board 52. The bottom faces of the connector housings 58, 58′ have a plurality of metalized contact areas 72 for connecting the leads 68 in the connector housings 58, 58′ with a plurality of metalized contact areas 74 on the mother board 54 and a plurality of metalized contact areas 76 on the face of the cable harness connector housing 63, respectively. Each of the insulating boards 60 has a plurality of circular openings 78 at positions corresponding to the contact areas 66 of the connector housings 58, 58′ and the contact areas 70 of the circuit board 52, while each of the insulating boards 62 has a plurality of openings 78 at positions corresponding to the contact areas 72 of the connector housings 58, 58′ and the contact areas 74 of the mother board 54 and the contact areas 76 of the cable harness connector housing 63, respectively.

Electrical connections between the contact areas 70 of the circuit board 52 and the contact areas 66 of the connector housings 58, 58′ and between the contact areas 72 of the connector housings 58, 58′ and the contact areas 74, 76 of the mother board 54 and cable harness connector housing 63, respectively, are established with wadded-wire connector elements 30 positioned in the openings 78 of the insulating boards 60, 62. Compressing the connector housings 58, 58′ and the circuit board 52 together causes the wadded-wire connector elements 30 to be compressed against the metalized contact areas 70, 66 and compressing the connector housings 58, 58′ and the mother board 54 and cable harness 56 together, respectively, causes the wadded-wire connector elements 30 to be compressed against the metalized contact areas 72, 74, 76. Compression of the connector housing 58 and the mother board 54 is provided by a bolt 82 that engages a threaded hole 84 in the mother board 54 and compression of the connector housing 58 and the circuit board 52 is provided by a bolt 86 that engages a threaded hole 88 in the circuit board 52.

The circuit boards 52 employed in the illustrated embodiments preferably have four to six rows of contact areas 70 along each edge. The contact areas 70 are spaced on centers of between 0.030 to 0.040 inches, thereby providing approximately 800 contacts along each edge of a circuit board.

Figure 6 shows a coaxial cable connector 100 for making electrical connections between a first coaxial cable 102 and a second coaxial cable 104. The coaxial cable connector 100 includes a connector housing 106 rotatably attached at the end of the first coaxial cable 102 and having a threaded inside surface, a collar 108 rigidly attached at the end of the second coaxial cable 104 and having a threaded outside surface for engagement with the threaded inside surface of the connector housing 106, and a circular insulating board 110 interposed between the ends of the two coaxial cables 102, 104. The insulating board 110 has a single circular opening 112 at its center, with a wadded-wire connector element 30 positioned in the opening 112 to electrically connect a center conductor 114 of the first coaxial cable 102 with a center conductor 116 of the second coaxial cable 104. An annular-shaped woven wire mesh 118, positioned about the circumference of the insulating board 110, electrically connects the outer conductors of the two coaxial cables 102, 104.

The insulating board 110, which in the presently preferred embodiment of the invention is fabricated from Teflon, fits within an alignment ring 120 that slips over the outer surfaces of the two coaxial cables 102, 104 to properly align the opening 112 with the center conductors of the two coaxial cables 102, 104. Compressing the two coaxial cables 102, 104 together by screwing the threaded connector housing 106 onto the threaded collar 108 causes the wadded-wire connector element 30 and the woven wire mesh 118 to be compressed against the ends of the center and outer conductors, respectively, thus making electrical connections between the center and outer conductors.

## Claims

1. An electrical connector for making electrical connections between contact areas (22; 66, 70; 72, 74; 72, 76; 114, 116) on two electronic components (12; 52, 54; 52, 56; 102, 104), comprising a connector housing (14; 58; 58'; 106) attached to one of the electronic components (12; 52; 102), an insulating board (18; 60; 62; 110) disposed between the contact areas (22; 66, 70; 72, 74; 72, 76; 114, 116) of the two electronic components (12; 52, 54; 52, 56; 102, 104), the insulating board (18; 60; 62; 110) having one or more openings (28; 78; 112) at a position or positions corresponding to the contact areas (22; 66, 70; 72, 74; 72, 76; 114, 116), one or more conductive connector elements (30) disposed respectively in the opening (112) or in selected ones of the openings (28; 78) in the insulating board (18; 60; 62; 110), and means (36, 38, 40; 82, 84, 86, 88; 106, 108)for urging the connector housing (14; 58; 58'; 106) and the two electronic components (12; 52, 54; 52, 56; 102, 104) towards one another thereby compressing the or each conductive connector element (30) and making electrical contact between the contact areas (22; 70, 74; 70, 76; 114, 116) of the two electrical components (12; 52, 54; 52, 56; 102, 104), characterised in that the or each conductive connector element (30) includes a wadded strand of conductive wire that is deformed when compressed and makes multiple electrical contacts with the contact areas (22; 70, 74; 70, 76; 114, 116) of the two electronic components (12; 52, 54; 52, 56; 102, 104).

2. An electrical connector as claimed in claim 1, wherein the electronic components (12) are two cable harnesses (12), the connector housing (14) being attached to one cable harness (12) and a second connector housing (16) being provided which is attached to the other cable harness, each connector housing (14; 16) having a plurality of the contact areas (22) to which leads (24; 26) from an associated one of the cable harnesses (12) are connected, the insulating board (18) being disposed between the two connector housings (14, 16), the insulating board (18) having a plurality of the openings (28) at positions corresponding to the contact areas (22) of the two connector housings (14, 16), the compressing means (36, 38, 40) urging the connector housings (14, 16) towards one another thereby effecting said compressing of the conductive connector elements (30) and making electrical contact between the contact areas (22) of the two connector housings (14, 16).

3. An electrical connector as claimed in claim 1, wherein one of the electronic components (52, 54; 52, 56) is a circuit board (52; 54) having an edge with said contact areas (70; 74), the connector housing (58; 58') being an edge card connector housing having a plurality of said contact areas (66; 72) to which leads (68) from the electronic component (52; 54; 56) are connected, the insulating board (60; 62) being disposed between the connector housing (58; 58') and the circuit board (52; 54), the insulating board (60; 62) having a plurality of said openings (78) at positions corresponding to the contact areas (66, 70, 72 74) of the connector housing (58; 58') and the circuit board (52; 54), a plurality of the conductive connector elements (30) being disposed in selected ones of the openings (78) in the insulating board (60; 62), the compressing means (82, 84, 86, 88) urging the connector housing (58; 58') and the circuit board (52; 54) towards one another thereby effecting said compression of the conductive connector elements (30) and making electrical contact between the connector housing (58; 58') and the circuit board (52; 54) contact areas (70; 74).

4. An electrical connector as claimed in claim 3, wherein the connector housing (58; 58') has a first plurality of said contact areas (66) for connecting leads (68) in the connecting housing (58; 58') to the contact areas (70) of the circuit board (52) and a second plurality of said contact areas (72) for connecting the leads (68) in the connector housing (58; 58') to contact areas (74; 76) on the electronic component (54; 56), a second insulating board (62) being disposed between the connector housing (58; 58') and the electronic component (54; 56), the second insulating board (62) having openings (78) at positions corresponding to the contact areas (74; 76) of the connector housing (58; 58') and the electronic component (54; 56), further said conductive connector elements (30) being disposed in selected ones of the openings (78) in the second insulating board (62), the compressing means (82, 84) urging the connector housing (58; 58') and the electronic component (54; 56) towards one another thereby effecting compression of the further conductive elements (30) and making electrical contact between the contact areas (72, 74; 72, 76) of the connector housing (58; 58') and the electronic component (54; 56).

5. An electrical connector as claimed in claim 4, wherein the electronic component (54; 56) is a second circuit board (54) or a cable harness (56).

6. An electrical connector as claimed in claim 4 or claim 5, wherein the second insulating board (62) is fabricated from a glass ceramic or a plastic.

7. An electrical connector as claimed in claim 1, wherein the electronic components (102, 104) are two coaxial cables (102, 104), each coaxial cable (102; 104) having a said contact area (114; 116) in the form of the end of a center conductor (114; 116), each coaxial cable (102; 104) also having an outer conductor, the connector housing (106) being attached to one (102) of the coaxial cables (102; 104), the insulating board (110) being disposed between the ends of the two coaxial cables (102, 104), the insulating board (110) having a single said opening (112) at a position corresponding to the center conductor (114; 116) of each of the coaxial cables (102, 104), the conductive connector element (30) being disposed in the opening (112) of the insulating board (110), a second conductive connector element (118) being disposed about the circumference of the insulating board (110), the compressing means (106, 108) urging the connector housing (106) and the two coaxial cables (102, 104) towards one another thereby effective said compression of the conductive connector element (30) and also compression of the second conductive connector element (118) and making electrical contact between the center conductors (114, 116) and the outer conductors.

8. An electrical connector as claimed in claim 7, wherein the second conductive connector element (118) includes an annular-shaped woven wire mesh that is deformed when compressed and makes multiple electrical contacts with the ends of the two outer conductors.

9. An electrical connector as claimed in any of the preceding claims, wherein the means for compressing (36, 38, 40; 82, 84, 86, 88; 106, 108) includes a screw mechanism (36, 38, 40; 82, 84, 86, 88; 106, 108).

10. An electrical connector as claimed in any of claims 1 to 6, wherein the means for compressing (36, 38, 40; 82, 84, 86, 88) includes a clamp mechanism (36, 38, 40; 82, 84, 86, 88).

11. An electrical connector as claimed in any of the preceding claims, wherein the or each wadded strand of wire has a density of approximately 20 to 30 percent.

12. An electrical connector as claimed in any of the preceding claims, wherein the or each wadded strand of wire is a nickel wire.

13. An electrical connector as claimed in any of claims 1 to 11, wherein the or each wadded strand of wire is an alloy wire, the alloy being selected from a group consisting of beyllium and copper, silver and copper, and phosphorus and bronze.

14. An electrical connector as claimed in any of the preceding claims, wherein the insulating board (18; 60; 62; 110) is fabricated from a glass ceramic or a plastic.

## Patentansprüche

1. Elektrischer Steckverbinder zum Herstellen elektrischer Verbindungen zwischen Kontaktflächen (22; 66, 70; 72, 74; 72, 76; 114, 116) an zwei elektronischen Bauteilen (12; 52, 54; 52, 56; 102, 104), mit einem Steckverbindergehäuse ( 14; 58; 58'; 106) das an einem der elektronischen Bauteile (12; 52; 102) befestigt ist, einer Isolierplatte (18; 60; 62; 110) die zwischen den Kontaktflächen (22; 66, 70; 72, 74; 72, 76; 114, 116) der beiden elektronischen Bauteile (12; 52, 54; 52, 56; 102, 104) angeordnet ist, wobei die Isolierplatte (18; 60; 62; 110) eine oder mehrere Öffnungen (28; 78; 112) an einer Stelle oder an Stellen hat, die den Kontaktflächen (22; 66, 70; 72, 74; 72, 76; 114, 116) entsprechen, einem oder mehreren leitfähigen Verbindungselementen (30), die jeweils in der Öffnung (112) oder in ausgewählten Öffnungen (28; 78) in der Isolierplatte (18; 60; 62; 110) angeordnet sind, und Mitteln (36, 38, 40; 82, 84, 86, 88; 106, 108), um das Steckverbindergehäuse (14; 58; 58'; 106) und die beiden elektronischen Bauteile (12; 52, 54; 52, 56; 102, 104) gegeneinanderzupressen und dadurch das oder die leitfähigen Verbindungselemente (30) zusammenzupressen und einen elektrischen Kontakt zwischen den Kontaktflächen (22; 70, 74; 70, 76; 114, 116) der beiden elektrischen Bauteile (12; 52, 54; 52, 56; 102, 104) herzustellen, dadurch gekennzeichnet, daß das oder jedes leitfähige Verbindungselement (30) einen gepolsterten, leitfähigen Litzendraht aufweist, der sich beim Zusammenpressen verformt und mehrfach elektrischen Kontakt mit den Kontaktflächen 22; 70, 74; 70, 76; 114, 116) der beiden elektronischen Bauteile (12; 52, 54; 52, 56; 102, 104) herstellt.

2. Elektrischer Steckverbinder nach Anspruch 1,
bei dem die elektronischen Bauteile (12) zwei Kabelsätze (12) sind, wobei das Steckverbindergehäuse (14) mit einem Kabelsatz (12) und ein zweites Steckverbindergehäuse (16) das mit dem anderen Kabelsatz verbunden ist, vorgesehen sind, jedes Steckverbindergehäuse (14; 16) eine Vielzahl von den Kontaktflächen (22) aufweist, mit denen Anschlüsse (24; 16) von einem zugehörigen der Kabelsätze (12) verbunden sind, die Isolierplatte (18) zwischen den beiden Steckverbindergehäusen (14; 16) angeordnet ist, die Isolierplatte eine Vielzahl der Öffnungen (28) an Stellen aufweist, die mit den Kontaktflächen (22) an den beiden Steckverbindergehäusen (14, 16) übereinstimmen, die Mittel zum Zusammenpressen (36, 38, 40) die Steckverbindergehäuse (14, 16) gegeneinanderpressen, um dadurch das Zusammenpressen der leitfähigen Verbindungselemente (30) zu bewirken und einen elektrischen Kontakt zwischen den Kontaktflächen (22) der beiden Steckverbindergehäuse (14, 16) herzustellen.

3. Elektrischer Steckverbinder nach Anspruch 1,
bei dem eines der elektronischen Bauteile (52, 54; 52, 56) eine Leiterplatte (52; 54) ist, die eine Kante mit den Kontaktflächen (70; 74) aufweist, das Steckverbindergehäuse (58, 58') ein Steckkartenrand-Steckverbindergehäuse mit einer Vielzahl von Kontaktflächen (66; 72) ist, an die Anschlüsse (68) von dem elektronischen Bauteil (52; 54; 56) angeschlossen sind, die Isolierplatte (60; 62) zwischen dem Steckverbindergehäuse (58; 58') und der Leiterplatte ( 52; 54) angeordnet ist, die Isolierplatte ( 60; 62) eine Vielzahl der Öffnungen (78) an Stellen aufweist, die den Kontaktflächen (66, 70, 72, 74) des Steckverbindergehäuses (58; 58') und der Leiterplatte (52; 54) entsprechen, eine Vielzahl der leitfähigen Steckverbinderelemente (30) in ausgewählten Öffnungen (78) in der Isolierplatte (60; 62) angeordnet sind, die Mittel zum Zusammenpressen (82, 84, 86, 88) das Steckverbindergehäuse (58; 58') und die Leiterplatte (52; 54) aneinanderpressen, um dadurch das Zusammenpressen der leitfähigen Verbindungselemente (30) zu bewirken und einen elektrischen Kontakt zwischen dem Steckverbindergehäuse (58; 58') und den Leiterplatten (52; 54) - Kontaktflächen (70; 74) herzustellen.

4. Elektrischer Steckverbinder nach Anspruch 3,
bei dem das Steckverbindergehäuse (58; 58') mehrere erste Kontaktflächen (66) zum Verbinden von Anschlüssen (68) in dem Steckverbindergehäuse (58; 58') mit den Kontaktflächen (70) der Leiterplatte (52) und mehrere zweite Kontaktflächen (72) zum Verbinden der Anschlüsse (68) in dem Steckverbindergehäuse (58; 58') mit Kontaktflächen (75; 76) an dem elektronischen Bauteil (54; 56) aufweist, eine zweite Isolierplatte (62) zwischen dem Steckverbindergehäuse (58; 58') und dem elektronischen Bauteil (54; 56) angeordnet ist, die zweite Isolierplatte (62) Öffnungen (78) an Stellen aufweist, die den Kontaktflächen (74; 76) des Steckverbindergehäuses (58; 58') und dem elektronischen Bauteil (54; 56) entsprechen, desweiteren leitfähige Verbindungselemente (30) in ausgewählten Öffnungen (78) in der zweiten Isolierplatte (62) angeordnet sind, die Mittel zum Zusammenpressen (82, 84) das Steckverbindergehäuse (58; 58') und das elektronische Bauteil (54, 56) gegeneinanderpressen, um dadurch ein Zusammenpressen der weiteren leitfähigen Elemente (30) zu bewirken und einen elektrischen Kontakt zwischen den Kontaktflächen (72, 74; 72, 76) des Steckverbindergehäuses (58; 58') und dem elektronischen Bauteil (54; 56) herzustellen.

5. Elektrischer Steckverbinder nach Anspruch 4,
bei dem das elektronische Bauteil (54; 56) eine zweite Leiterplatte (54) oder ein Kabelsatz (56) ist.

6. Elektrischer Steckverbinder nach Anspruch 4 oder 5,
bei dem die zweite Isolierplatte (62) aus Glaskeramik oder einem Kunststoff hergestellt ist.

7. Elektronischer Steckverbinder nach Anspruch 1,
bei dem die elektronischen Bauteile (102, 104) zwei Koaxialkabel (102, 104) sind, jedes Koaxialkabel (102, 104) eine Kontaktfläche (114; 116) in Gestalt des Endes des Mittelleiters (114; 116) hat, jedes Koaxialkabel (102; 104) auch einen Außenleiter hat, das Steckverbindergehäuse (106) mit einem (102) der Koaxialkabel (102; 104) verbunden ist, die Isolierplatte (110) zwischen den Enden der zwei Koaxialkabel (102, 104) angeordnet ist, die Isolierplatte (110) eine einzige Öffnung (112) an einer Stelle aufweist, die mit dem Mittelleiter (114; 116) von jedem der Koaxialkabel (102, 104) übereinstimmt, das leitfähige Verbindungselement (30) in der Öffnung (112) der Isolierplatte (110) angeordnet ist, ein zweites leitfähiges Verbindungselement (118) um den Umfang der Isolierplatte (110) angeordnet ist, die Mittel zum Zusammenpressen (106, 108) das Steckverbindergehäuse (106) und die beiden Koaxialkabel (102, 104) gegeneinanderpressen, um dadurch das Zusammenpressen des leitfähigen Verbindungselementes (30) und auch das Zusammenpressen des zweiten leitfähigen Verbindungselementes (118) zu bewirken und einen elektrischen Kontakt zwischen den Mittelleitern (114, 116) und den Außenleitern herzustellen.

8. Elektrischer Steckverbinder nach Anspruch 7,
bei dem das zweite leitfähige Verbindungselement (118) ein ringförmiges gewobenes Drahtgeflecht umfaßt, das beim Zusammenpressen verformt wird und mehrfachen elektrischen Kontakt mit den Enden der beiden Außenleiter herstellt.

9. Elektrischer Steckverbinder nach einem der vorhergehenden Ansprüche, bei dem die Mittel zum Zusammenpressen (36, 38, 40; 82, 84, 86, 88; 106, 108) einen Schraubenmechanismus (36, 38, 40; 82, 84, 86, 88; 106, 108) umfassen.

10. Elektrischer Steckverbinder nach einem der Ansprüche 1 bis 6, bei dem die Mittel zum Zusammenpressen (36, 38, 40; 82, 84, 86, 88) einen Klemmechanismus (36, 38, 40; 82, 84, 86, 88) umfassen.

11. Elektrischer Steckverbinder nach einem der vorhergehenden Ansprüche, bei dem der oder jeder gepolsterte Litzendraht eine Dichte von etwa 20 bis 30 % hat.

12. Elektrischer Steckverbinder nach einem der vorhergehenden Ansprüche, bei dem der oder jeder gepolsterte Litzendraht ein Nickeldraht ist.

13. Elektrischer Steckverbinder nach einem der Ansprüche 1 bis 11, bei dem der oder jeder gepolsterte Litzendraht ein Legierungsdraht ist, wobei die Legierung aus eine Gruppe bestehend aus Beryllium und Kupfer, Silber und Kupfer oder Phosphor und Bronze ausgewählt ist.

14. Elektrischer Steckverbinder nach einem der vorhergehenden Ansprüche, bei dem die Isolierplatte (18; 60; 62; 110) aus Glaskeramik oder einem Kunststoff hergestellt ist.

## Revendications

1. Un connecteur électrique pour établir des connexions électriques entre des zones de contact (22; 66, 70; 72, 74; 72, 76; 114, 116) sur deux composants électroniques (12; 52, 54; 52, 56; 102, 104), comprenant un corps de connecteur (14; 58; 58'; 106) fixé sur l'un des composants électroniques (12; 52; 102), une plaquette isolante (18; 60; 62; 110) disposée entre les zones de contact (22; 66, 70; 72, 74; 72, 76; 114, 116) des deux composants électroniques (12; 52, 54; 52, 56; 102, 194), la plaquette isolante (18; 60; 62; 110) ayant une ou plusieurs ouvertures (28; 78; 112) à une ou plusieurs positions correspondant aux zones de contact (22; 66, 70; 72, 74; 72, 76; 114, 116), un ou plusieurs éléments de connecteur conducteurs (30) disposés respectivement dans l'ouverture (112) ou dans certaines ouvertures sélectionnées (28; 78) dans la plaquette isolante (18; 60; 62; 110), et des moyens (36, 38, 40; 82, 84, 86, 88; 106, 108) pour appliquer les uns contre les autres le corps de connecteur (14; 58; 58'; 106) et les deux composants électroniques (12; 52, 54; 52, 56; 102, 104), pour comprimer ainsi l'élément de connecteur conducteur (30) ou chacun d'eux, et pour établir ainsi un contact électrique entre les zones de contact (22; 70, 74; 70, 76; 114, 116) des deux composants électroniques (12; 52, 54; 52, 56; 102, 104), caractérisé en ce que l'élément de connecteur conducteur (30), ou chacun d'eux, (30) comprend un tampon de fil conducteur auquel on a donné une structure de paille métallique, qui est déformé lorsqu'il est comprimé et qui établit des contacts électriques multiples avec les zones de contact (22; 70, 74; 70, 76; 114, 116) des deux composants électroniques (12; 52, 54; 52, 56; 102, 104).

2. Un connecteur électrique selon la revendication 1, dans lequel les composants électroniques (12) sont deux faisceaux de câbles (12), le corps de connecteur (14) est fixé à un faisceau de câbles (12) et il existe un second corps de connecteur (16) qui est fixé à l'autre faisceau de câbles, chaque corps de connecteur (14; 16) comprend un ensemble des zones de contact (22) auxquelles sont connectés des conducteurs (24; 26) provenant de l'un associé des faisceaux de câbles (12), la plaquette isolante (18) est disposée entre les deux corps de connecteurs (14, 16), la plaquette isolante (18) comprend un ensemble d'ouvertures (28) dans des positions correspondant aux zones de contact (22) des deux corps de connecteur (14, 16), et les moyens de compression (36, 38, 40) sollicitent l'un vers l'autre les corps de connecteur (14, 16), pour réaliser ainsi la compression précitée des éléments de connecteur conducteurs (30), et pour établir un contact électrique entre les zones de contact (22) des deux corps de connecteur (14, 16).

3. Un connecteur électrique selon la revendication 1, dans lequel l'un des composants électroniques (52, 54; 52, 56) est une carte de circuit (52; 54) ayant un bord sur lequel sont formées les zones de contact (70; 74), le corps de connecteur (58, 58') est un corps de connecteur de bord de carte ayant un ensemble des zones de contact (66; 72) auxquelles sont connectés des conducteurs (68) provenant du composant électrique (52; 54; 56), la plaquette isolante (60; 62) est disposée entre le corps de connecteur (58; 58') et la carte de circuit (52; 54), la plaquette isolante (60; 62) comprend un ensemble des ouvertures précitées (78) à des positions correspondant aux zones de contact (66, 70, 72, 74) du corps de connecteur (58; 58') et de la carte de circuit (52; 54), un ensemble des éléments de connecteur conducteurs (30) sont disposés dans certaines ouvertures sélectionnées parmi les ouvertures (78) qui sont formées dans la plaquette isolante (60; 62), et les moyens de compression (82, 84, 86, 88) sollicitent l'un vers l'autre le corps de connecteur (58; 58') et la carte de circuit (52; 54), pour réaliser ainsi la compression précitée des éléments de connecteur conducteurs (30) et pour établir ainsi un contact électrique entre le corps de connecteur (58; 58') et les zones de contact (70; 74) de la carte de circuit (52; 54).

4. Un connecteur électrique selon la revendication 3, dans lequel le corps de connecteur (58; 58') comporte un premier ensemble des zones de contact (66) pour connecter des conducteurs (68) dans le corps de connecteur (58; 58') aux zones de contact (70) de la carte de circuit (52), et un second ensemble des zones de contact (72) pour connecter les conducteurs (68) dans le corps de connecteur (58; 58') à des zones de contact (74; 76) sur le composant électrique (54; 56), une seconde plaquette isolante (62) est disposée entre le corps de connecteur (58; 58') et le composant électronique (54; 56), la seconde plaquette isolante (62) comporte des ouvertures (78) dans des positions correspondant aux zones de contact (74; 76) du corps de connecteur (58; 58') et du composant électronique (54; 56), des éléments de connecteur conducteurs (30) supplémentaires sont disposés dans des ouvertures sélectionnées parmi les ouvertures (78) qui sont formées dans la seconde plaquette isolante (62), et les moyens de compression (82, 84) sollicitent l'un vers l'autre le corps de connecteur (58; 58') et le composant électronique (54; 56), pour réaliser ainsi la compression des éléments conducteurs supplémentaires (30) et pour établir ainsi un contact électrique entre les zones de contact (72, 74; 72, 76) du corps de connecteur (58; 58') et le composant électronique (54; 56).

5. Un connecteur électrique selon la revendication 4, dans lequel le composant électronique (54; 56) est une seconde carte de circuit (54) ou un faisceau de câbles (56).

6. Un connecteur électrique selon la revendication 4 ou la revendication 5, dans lequel la seconde plaquette isolante (62) est fabriquée à partir d'une vitrocéramique ou d'une matière plastique.

7. Un connecteur électrique selon la revendication 1, dans lequel les composants électroniques (102, 104) sont deux câbles coaxiaux (102, 104) chaque câble coaxial (102; 104) comporte une zone de contact précitée (114; 116) se présentant sous la forme de l'extrémité d'un conducteur central (114; 116), chaque câble coaxial (102; 104) comporte également un conducteur extérieur, le corps de connecteur (106) est fixé à l'un (102) des câbles coaxiaux (102; 104), la plaquette isolante (110) est disposée entre les extrémités des deux câbles coaxiaux (102, 104), la plaquette isolante (110) comporte une seule ouverture précitée (112), dans une position correspondant au conducteur central (114; 116) de chacun des câbles coaxiaux (102, 104), l'élément de connecteur conducteur (30) est disposé dans l'ouverture (112) de la plaquette isolante (110), un second élément de connecteur conducteur (118) est disposé autour de la circonférence de la plaquette isolante (110), et les moyens de compression (106, 108) sollicitent les uns vers les autres le corps de connecteur (106) et les deux câbles coaxiaux (102, 104) pour réaliser ainsi la compression précitée de l'élément de connecteur conducteur (30), et également la compression du second élément de connecteur conducteur (118), et pour établir ainsi un contact électrique entre les conducteurs centraux (114, 116) et les conducteurs extérieurs.

8. Un connecteur électrique selon la revendication 7, dans lequel le second élément de connecteur conducteur (118) comprend une tresse de fil métallique de forme annulaire qui est déformée lorsqu'elle est comprimée, et qui établit des contacts électriques multiples avec les extrémités des deux conducteurs extérieurs.

9. Un connecteur électrique selon l'une quelconque des revendications précédentes, dans lequel les moyens de compression (36, 38, 40; 82, 84, 86; 106, 108) comprennent un mécanisme à vis (36, 38, 40; 82, 84, 86; 106, 108).

10. Un connecteur électrique selon l'une quelconque des revendications 1 à 6, dans lequel les moyens de compression (36, 38, 40; 82, 84, 86, 88) comprennent un mécanisme de serrage (36, 38, 40; 82, 84, 86, 88).

11. Un connecteur électrique selon l'une quelconque des revendications précédentes, dans lequel le tampon de fil auquel on a donné une structure de paille métallique, ou chacun d'eux, a une densité d'environ 20 à 30%.

12. Un connecteur électrique selon l'une quelconque des revendications précédentes, dans lequel le tampon de fil auquel on a donné une structure de paille métallique, ou chacun d'eux, est formé par un fil de nickel.

13. Un connecteur électrique selon l'une quelconque des revendications 1 à 11, dans lequel le tampon de fil auquel on a donné la structure d'une paille métallique, ou chacun d'eux, est formé par un fil d'alliage, cet alliage étant sélectionné dans un groupe qui comprend le béryllium et le cuivre, l'argent et le cuivre, et le phosphore et le bronze.

14. Un connecteur électrique selon l'une quelconque des revendications précédentes, dans lequel la plaquette isolante (18; 60; 62; 110) est fabriquée à partir d'une vitrocéramique ou d'une matière plastique.
